# EUROPÄISCHE PATENTSCHRIFT

(11) **EP 1 136 833 B1**
(45) Veröffentlichungstag und Bekanntmachung des Hinweises auf die Patenterteilung: **26.01.2005**
(21) Anmeldenummer: 01104285.0
(22) Anmeldetag: 22.02.2001
(51) Int. Cl.: G01R 31/316

(54) **Verfahren zur Durchführung eines Burn-in-Prozesses zum elektrischen Stressen eines Halbleiterspeichers**
Method of performing a burn-in process to electrically stress a semiconductor memory
Méthode d' exécution d' un procédé de vieillissement par contrainte électrique pour une mémoire à semi-conducteur

(30) Priorität: 23.03.2000 DE 10014388
(43) Veröffentlichungstag der Anmeldung: 26.09.2001
(73) Patentinhaber: Infineon Technologies AG, 81669 München (DE)
(72) Erfinder: Ayadi, Kamel, Dr., 82178 Puchheim (DE); Lindolf, Jürgen, Dr., 86316 Friedberg (DE); Oezoguz-Geissler, Nedim, 82024 Taufkirchen (DE)
(74) Vertreter: Epping, Hermann, Fischer

(56) Entgegenhaltungen:
- WO-A-82/00917
- DE-A- 19 603 107
- US-A- 5 557 559
- US-A- 5 872 797
- US-A- 6 038 181

## Beschreibung

Die Erfindung betrifft ein Verfahren zur Durchführung eines Burn-in-Prozesses zum elektrischen Stressen eines Halbleiterspeichers, wobei das Verfahren die folgenden Schritte aufweist:
- Bereitstellen eines Halbleiterspeichers, der eine Schaltungsanordnung mit einem ersten Spannungsanschluß und einem zweiten Spannungsanschluß und einem Steuereingang aufweist, wobei die Schaltungsanordnung einen MOS-Transistor umfaßt;
- Anlegen eines Bezugspotentials an den ersten Spannungsanschluß;
- Anlegen einer zweiten Spannung an den zweiten Spannungsanschluß und
- Anlegen einer Steuerspannung an den Steuereingang.

Halbleiterspeicher werden zur Informationsspeicherung verwendet und können als Halbleiterbauelement realisiert werden. Ein Halbleiterspeicher ist z.B. ein DRAM (Dynamic Random Access Memory). Es umfaßt aus einem Zellenfeld mit Speicherzellen und einer Ansteuerungsperipherie. Die Speicherzellen des Speicherzellenfeldes bestehen aus einem Auswahltransistor und einem Speicherkondensator. Die Ansteuerungsperipherie wird üblicherweise aus Transistoren gebildet, die in CMOS-Technologie gefertigt sind. CMOS bedeutet Complementary Metal Oxyd Semiconductor und enthält sowohl N-MOS- als auch P-MOS-Transistoren verwendet werden.

Um über die gesamte Lebenszeit eines Speicherproduktes eine hohe Zuverlässigkeit der verwendeten Transistoren zu gewährleisten, wird ein Burn-in-Prozeß durchgeführt. Transistoren sind herstellungsbedingt nicht in der Lage, während ihrer gesamten Lebenszeit ein identisches Verhalten beizubehalten, was sich in einer über die Zeit veränderten Eingangs- und Ausgangskennlinie widerspiegelt. Die Veränderung der Transistoren wird z.B. durch sogenannte Hot Carrier Injection (Injektion von hochenergetischen Ladungsträgern) bewirkt, was sich bei Transistoren mit kurzer Kanallänge in immer stärkerem Maße auswirkt. Die Einsatzspannung eines frisch produzierten Transistors ist nicht stabil, da hochenergetische Ladungsträger in dem Gate-Oxid akkumuliert werden. Die Einführung eines Burn-in-Prozesses ermöglicht die Stabilisierung der Transistoreigenschaften auf einen konstanten Wert. Diese Stabilisierung wird während der Burn-in-Phase durchgeführt, während sich der Speicher in einer Testumgebung befindet, so daß Der Baustein im Betrieb stabile Eigenschaften aufweist. Üblicherweise werden die Burn-in-Prozesse in einem Ofen durchgeführt, in dem die Speicher einer erhöhten Temperatur ausgesetzt werden. Druckschriften, in denen die Durchführung eines Burn-in beschrieben wird, sind die Patente US 5,976,899; US 5,917,765; US 5,898,186; US 5,748,543; US 5,636,171; US 6,018,485. Zwei Druckschriften, die Schaltkreise zum Durchführen eines Burn-in beschreiben, sind die Patentschriften US 5,986,917 und US 5,424,990. Weitere Erkenntnisse zum Stressen von MOS-Transistoren sind in Zhi Chen et. al. "On the Mechanism for Interface Trap Generation in MOS Transistors Due to Channel Hot Carrier Stressing", IEEE Electron Device Letters, Vol. 21, No. 1, January 2000, p. 24.

US 5,872,797 offenbart eine Einrichtung zum schnelleren Zugriff auf Speicherdaten während der Durchführung einen Burn-in-Prozesses. WO 82/00917 und US 6,038,181 offenbaren jeweils ein Verfahren zur Durchführung eines Burn-in-Prozesses, bei denen zumindest ein Bezugspotential an einen ersten Spannungsanschluß eines Halbleiterspeicher angelegt wird. DE 196 03 107 A1 offenbart ein Verfahren der eingangs genannten Art zur Durchführung eines Burn-in-Prozesses zum elektrischen Stressen eines Halbleiterspeichers. Bei dem Verfahren werden ein Bezugspotential an einen ersten Spannungsanschluß, eine zweite Spannung an einen zweiten Spannungsanschluß und eine Steuerspannung an einen Steuereingang eines Halbleiterspeichers angelegt.

Es ist die Aufgabe der vorliegenden Erfindung, ein Verfahren zur Durchführung eines Burn-in-Prozesses anzugeben, mit dem ein Halbleiterspeicher effizienter gestresst wird und die elektrische Charakteristik des Halbleiterspeichers schneller stabilisiert wird.

Diese Aufgabe wird erfindungsgemäß dadurch gelöst, daß bei .dem eingangs genannten Verfahren die zweite Spannung und die Steuerspannung mit derselben Frequenz zwischen dem Bezugspotential und einer Betriebsspannung alternieren und daß eine Phasendifferenz zwischen der zweiten Spannung und der Steuerspannung variiert wird.

Der Mechanismus, auf dem der erfindungsgemäße Burn-in-Prozeß beruht, ist dynamisches Stressen eines MOS-Transistors. Um einen MOS-Transistor zu stressen, wird z.B. sein Source-Anschluß an ein Bezugspotential, sein Drain-Anschluß an eine Betriebsspannung und sein Gate-Anschluß an eine alternierende Spannung angelegt, die Werte zwischen dem Bezugspotential und der Betriebsspannung annimmt. Die Spannung am Drain-Anschluß wird z.B. größer gewählt, als die Spannung am Gate-Anschluß. Die Eigenschaften eines Transistors verändern sich unter diesen Streßbedingungen in wenigen Stunden so sehr, wie bei normalem Betrieb in zwei Jahren. Dadurch stabilisiert sich seine Eingangsspannung und bleibt während seiner erwarteten zehnjährigen Betriebszeit beim Kunden bei normalem Betrieb in dem Speicher konstant. Vorteilhafterweise kann ein durch den Streß veränderter Transistor in der Speicherschaltungsperipherie bereits während der Testphase identifiziert werden, so daß der defekte Speicher nicht als Produkt ausgeliefert wird. Unter Einwirkung von Streß wird beispielsweise die Einsatzspannung des Transistors verändert und stabilisiert sich. In der Schaltungsperipherie sind kombinatorische Blöcke angeordnet, die Transistoren enthalten.

Bei dem erfindungsgemäßen Verfahren nimmt die Steuerspannung Spannungswerte an, die zwischen dem Bezugspotential und einer Betriebsspannung alternieren.

Bei dem erfindungsgemäßen Verfahren ist vorgesehen, daß die an dem zweiten Spannungsanschluß anliegende zweite Spannung und die an dem Steuereingang anliegende Steuerspannung zwischen dem Bezugspotential und der Betriebsspannung alternieren. Dadurch wird eine beschleunigte Alterung der Schaltungsanordnung erreicht und der Streß für die Schaltungsanordnung erhöht, so daß die Zeit zum Stressen reduziert werden kann und der gleiche Streßeffekt in kürzerer Zeit erzielt wird.

Erfindungsgemäß ist schließlich vorgesehen, daß die zweite Spannung und die Steuerspannung mit derselben Frequenz zwischen der Betriebsspannung und dem Bezugspotential alternieren und daß die Phasendifferenz zwischen der zweiten Spannung und der Steuerspannung variiert wird. Durch die Variation der Phasendifferenz kann eine Vielfalt von Konstellationen der Betriebsspannung und Steuerspannung erzeugt werden. Dadurch wird der Streß der Schaltungsanordnung weiter erhöht, was die Zeit für den Burn-in-Prozesses vermindert.

Eine Ausführungsform des erfindungsgemäßen Verfahrens sieht vor, daß die Schaltungsanordnung einen Inverter enthält, wobei an einen Invertereingang die Steuerspannung, an eine erste Inverterspannungsversorgung das Bezugspotential und an eine zweite Inverterspannungsversorgung die zweite Spannung angelegt wird. Durch diese Anordnung wird erreicht, daß ein zu stressender Transistor in der Schaltungsanordnung angeordnet ist. Darüber hinaus ist vorgesehen, daß die Schaltungsanordnung einen Inverter enthält. Ein Inverter ist das Basiselement einer jeden CMOS-Schaltung und ist auch in der Schaltungsperipherie eines Speichers enthalten. Weiterhin sind in den Schaltungsblöcken logische Funktionen wie AND, NAND, OR, NOR, XOR etc. enthalten.

Vorzugsweise ist vorgesehen, daß die zweite Spannung und die Steuerspannung eine Phasendifferenz zwischen 150 bis 210 Grad aufweisen. Eine Phasendifferenz von 180 Grad bedeutet, daß sich die beiden Signale genau gegenphasig verhalten. Der Toleranzbereich zwischen 150 bis 210 Grad Phasenverschiebung ermöglicht eine Variation der Phasenverschiebung in dem angegebenen Bereich, was verschiedenste Streßkonstellationen für die Schaltungsanordnung bedeutet.

Schließlich ist vorzugsweise vorgesehen, daß der Halbleiterspeicher ein DRAM ist.

Die Erfindung wird nachfolgend anhand eines Ausführungsbeispiels und anhand der Figuren näher erläutert. Es zeigen:
- Figur 1: ein Diagramm mit einem Spannungsverlauf bei einem herkömmmlichen Burn-in-Test;
- Figur 2: ein Diagramm mit einem Spannungsverlauf bei einem erfindungsgemäßen Burn-in-Test;
- Figur 3: ein weiteres Diagramm zu dem erfindungsgemäßen Burn-in-Test;
- Figur 4: eine Schaltungsanordnung mit Spannungsversorgungsanschlüssen;
- Figur 5: ein Eingangskennlinienfeld eines P-Kanal-Transistors, bevor er gestreßt wurde;
- Figur 6: das Eingangskennlinienfeld eines P-Kanal-Transistors, nachdem er gestreßt wurde;
- Figur 7: die Veränderung der Einsatzspannung unter Einwirkung von Streß über der Zeit.

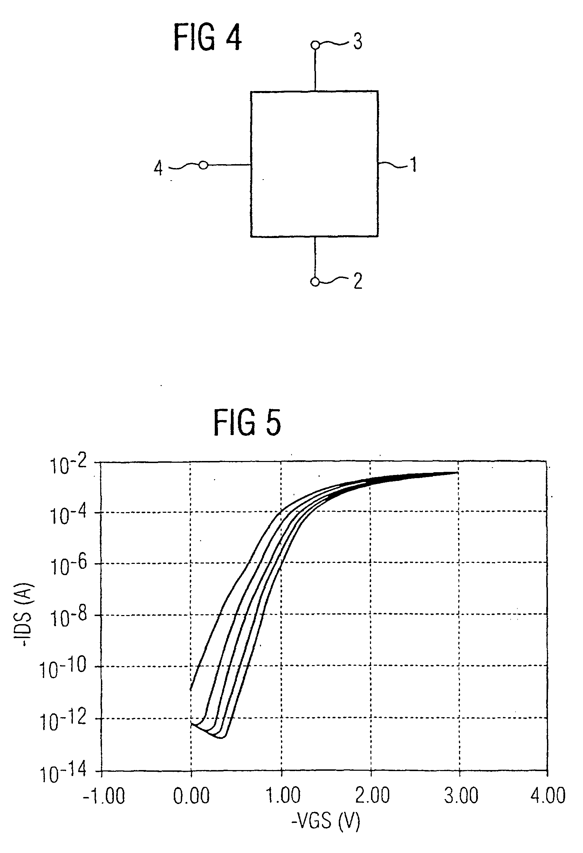

In Figur 4 ist eine Schaltungsanordnung 1 mit einem ersten Spannungsanschluß 2 einem zweiten Spannungsanschluß 3 und einem Steuereingang 4 dargestellt. In der Schaltungsanordnung 1 befindet sich ein logischer Block, der z.B. ein MOS-Transistor oder einen CMOS-Inverter enthält. Im folgenden werden Spannungsverläufe beschrieben, die dazu geeignet sind, die Schaltungsanordnung 1 zu stressen und so vorzeitig altern zu lassen, damit die Schaltungsanordnung 1 ein konstantes Verhalten annimmt.

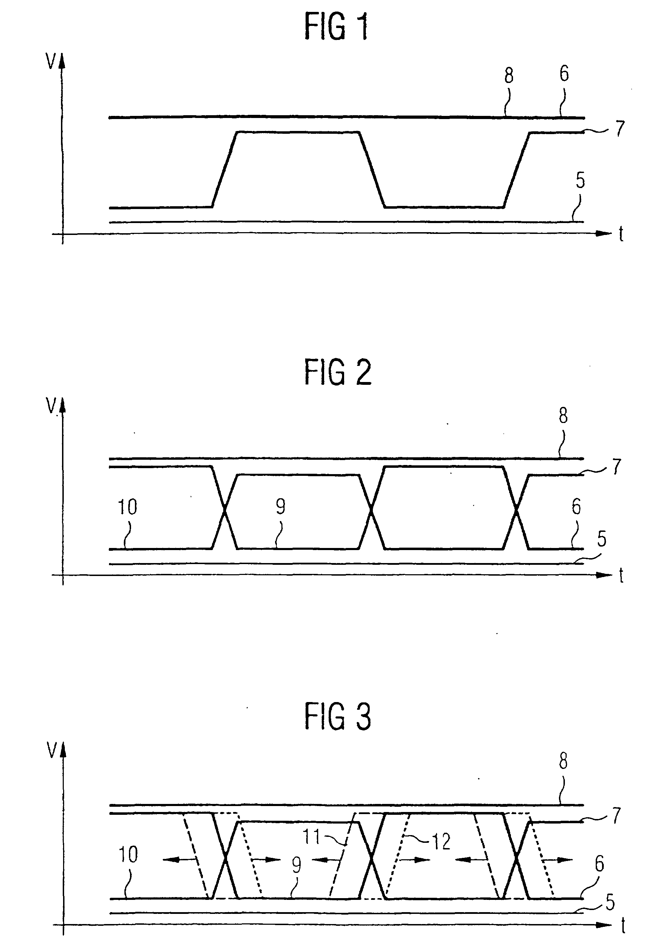

In Figur 1 ist auf der Abszisse die Zeit und auf der Ordinate die Spannung dargestellt. Weiterhin ist der Verlauf eines Bezugspotentials 5, der Verlauf einer Betriebsspannung 8, der Verlauf einer zweiten Spannung 6, die bei einem herkömmlichen Burn-in-Test mit dem Verlauf der Betriebsspannung identisch ist, und der Verlauf einer Steuerspannung 7 dargestellt. Die Steuerspannung 7 alterniert zwischen dem Bezugspotential 5 und der Betriebsspannung 8. Um die Schaltungsanordnung 1 mit dem Spannungsverlauf aus Figur 1 zu stressen, wird beispielsweise der erste Spannungsanschluß 2 an das Bezugspotential 5, der zweite Spannungsanschluß 3 an die zweite Spannung 6 und der Steuereingang 4 an die Steuerspannung 7 angeschlossen. Üblicherweise wird die Größe der Spannungen so gewählt, daß die von der Schaltungsanordnung 1 umfaßten Bauelemente einen Alterungsprozeß erfahren, allerdings nicht direkt durch Überspannungen zerstört werden.

In Figur 2 ist ein Spannungsverlauf bei einem erfindungsgemäßen Burn-in-Test dargestellt. Der Unterschied zu Figur 1 besteht darin, daß in Figur 2 die zweite Spannung 6 nicht konstant auf dem Wert der Betriebsspannung 8 gehalten wird, sondern ebenfalls zwischen dem Bezugspotential 5 und der Betriebsspannung 8 alterniert. Dabei oszillieren die zweite Spannung 6 und die Steuerspannung 7 mit derselben Frequenz 9 bzw. 10. Erfindungsgemäß sind die beiden Frequenzen 9, 10 identisch, die entsprechenden Spannungen weisen allerdings eine variierende Phasenverschiebung auf. Durch dieses Vorgehen wird die Schaltungsanordnung 1 in ihrem Alterungsprozeß beschleunigt.

In Figur 3 ist zusätzlich zu dem Spannungsverlauf des erfindungsgemäßen Burn-in-Tests die erfindungsgemäße Phasenvariation dargestellt. Gemäß Figur 3 ist die Phasenlage der zweiten Spannung 6 und der Steuerspannung 7 nicht konstant bei 180 Grad, sondern kann in einem Bereich von + 30 Grad variiert werden. Durch die Variation der Phasenlage wird der Streß auf die Schaltungsanordnung 1 weiter erhöht, so daß die zur beschleunigten Alterung (Burn-in) der Schaltungsanordnung 1 benötigte Zeit in vorteilhafter Weise reduziert werden kann.

Figur 5 zeigt ein Eingangskennlinienfeld eines P-Kanal-Transistors, welches direkt nach der Herstellung des P-Kanal-Transistors aufgenommen worden ist. Die fünf dargestellten Kennlinien gehören zu unterschiedlichen Source-Drain-Spannungen, wobei die unterste Kennlinie der niedrigsten Source-Drain-Spannung und die oberste Kennlinie der höchsten Source-Drain-Spannung zugeordnet werden kann. Es ist zu erkennen, daß der Transistor auch bei hohen Source-Drain-Spannungen ein gutes Abschaltverhalten mit 10⁻¹¹ Ampere zeigt.

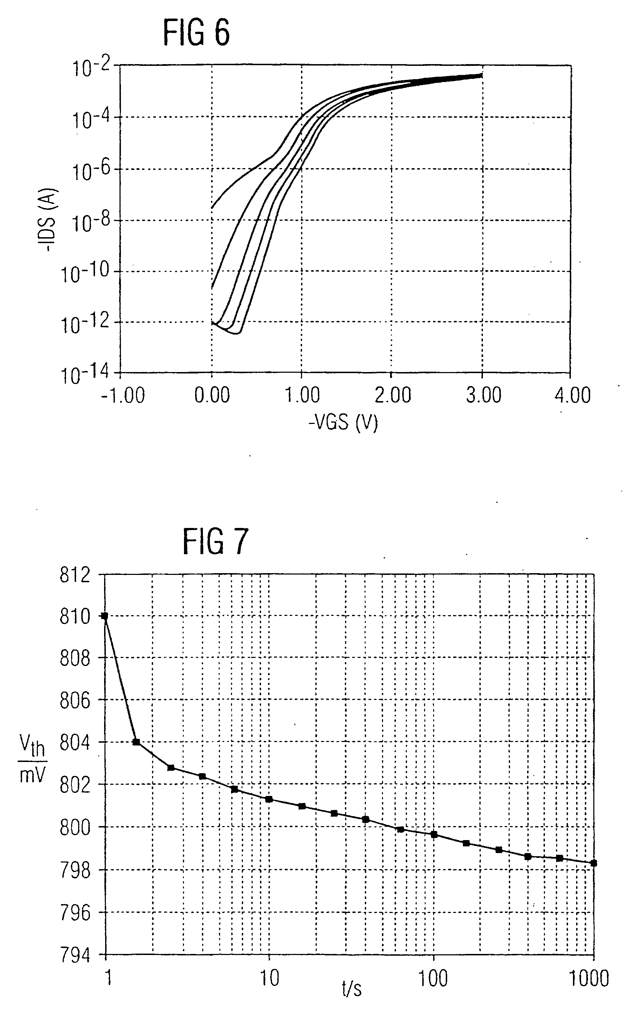

In Figur 6 ist das Eingangskennlinienfeld des aus Figur 5 bekannten Transistors nach dem erfindungsgemäßen Burn-in-Prozeß dargestellt. Deutlich ist zu erkennen, daß das Abschaltverhalten bei hohen Source-Drain-Spannungen nicht mehr sehr gut ist, da Source-Drain-Ströme von 10⁻⁷ Ampere fließen, was einen Faktor 10000 größer ist als vor dem Burn-in-Prozeß.

Mit Bezug auf Figur 7 ist die Variation der Einsatzspannung über der Zeit dargestellt. Deutlich ist zu erkennen, daß die Einsatzspannung im Laufe der Zeit abnimmt und sich stabilisiert.

Das Funktionsprinzip besteht darin, daß eine in dem Speicher vorhandene Frequenz die Transistoren der Schaltung ein- und ausschaltet. Gate- und Drain-Anschlüsse der Transistoren sind dabei über Kontakte mit der auf dem Speicherchip erzeugten und mit der Frequenz getakteten Spannung verbunden.

Weiterhin ist es vorteilhaft, einen Temperaturgradienten während der elektrischen Streßphase an den Speicher anzulegen, um die Streßphase zu verkürzen.

### Bezugszeichenliste

- 1: Schaltungsanordnung
- 2: erster Spannungsanschluß
- 3: zweiter Spannungsanschluß
- 4: Steuereingang
- 5: Bezugspotential
- 6: zweite Spannung
- 7: Steuerspannung
- 8: Betriebsspannung
- 9: erste Frequenz
- 10: zweite Frequenz
- 11: erste Phasenverschiebung
- 12: zweite Phasenverschiebung

## Patentansprüche

1. Verfahren zur Durchführung eines Burn-in-Prozesses zum elektrischen Stressen eines Halbleiterspeichers mit den Schritten:
- Bereitstellen eines Halbleiterspeichers, der eine Schaltungsanordnung (1) mit einem ersten Spannungsanschluß (2) und einem zweiten Spannungsanschluß (3) und einem Steuereingang (4) aufweist, wobei die Schaltungsanordnung (1) einen MOS-Transistor umfaßt;
- Anlegen eines Bezugspotentials (5) an den ersten Spannungsanschluß (2);
- Anlegen einer zweiten Spannung (6) an den zweiten Spannungsanschluß (3) und
- Anlegen einer Steuerspannung (7) an den Steuereingang (4),
**dadurch gekennzeichnet, daß**
- die zweite Spannung (6) und die Steuerspannung (7) mit derselben Frequenz (9; 10) zwischen dem Bezugspotential (5) und einer Betriebsspannung (8) alternieren und
- daß die Phasendifferenz (11) zwischen der zweiten Spannung (6) und der Steuerspannung (7) variiert wird.

2. Verfahren nach Anspruch 1,
**dadurch gekennzeichnet, daß**
die Schaltungsanordnung (1) einen Inverter enthält, wobei an einen Invertereingang die Steuerspannung (7), an eine erste Inverterspannungsversorgung das Bezugspotential (5) und an eine zweite Inverterspannungsversorgung die zweite Spannung (6) angelegt wird.

3. Verfahren nach Anspruch 1 oder 2,
**dadurch gekennzeichnet, daß**
die Phasendifferenz (11) zwischen 150 bis 210 Grad variiert wird.

4. Verfahren nach einem der Ansprüche 1 bis 3,
**dadurch gekennzeichnet, daß**
der Halbleiterspeicher ein DRAM ist.

## Claims

1. Method for carrying out a burn-in process for electrically stressing a semiconductor memory, having the steps of:
- providing a memory which has a circuit arrangement (1) having a first voltage terminal (2) and a second voltage terminal (3) and a control input (4), the circuit arrangement (1) comprising a MOS transistor;
- applying a reference potential (5) to the first voltage terminal (2);
- applying a second voltage (6) to the second voltage terminal (3), and
- applying a control voltage (7) to the control input (4),
**characterized in that**
- the second voltage (6) and the control voltage (7) alternate at the same frequency (9; 10) between the reference potential (5) and an operating voltage (8) and
- **in that** the phase difference (11) between the second voltage (6) and the control voltage (7) is varied.

2. Method according to Claim 1,
**characterized in that**
the circuit arrangement (1) contains an inverter, the control voltage (7) being applied to an inverter input, the reference potential (5) being applied to a first inverter voltage supply, and the second voltage (6) being applied to a second inverter voltage supply.

3. Method according to Claim 1 or 2,
**characterized in that**
the phase difference (11) is varied between 150 and 210 degrees.

4. Method according to one of Claims 1 to 3,
**characterized in that**
the semiconductor memory is a DRAM.

## Revendications

1. Procédé de mise en oeuvre d'un processus de vieillissement par contrainte électrique sur une mémoire à semi-conducteurs avec les étapes suivantes :
- mise à disposition d'une mémoire à semi-conducteurs qui comporte un circuit (1) avec une première borne de tension (2) et avec une deuxième borne de tension (3) et avec une entrée de commande (4), le circuit (1) comprenant un transistor MOS ;
- application d'un potentiel de référence (5) à la première borne de tension (2) ;
- application d'une deuxième tension (6) à la deuxième borne de tension (3) ; et
- application d'une tension de commande (7) à l'entrée de commande (4) ;
**caractérisé par le fait que**
- la deuxième tension (6) et la tension de commande (7) avec la même fréquence (9 ; 10) alternent entre le potentiel de référence (5) et une tension de fonctionnement (8), et
- la différence de phase (11) entre la deuxième tension (6) et la tension de commande (7) varie.

2. Procédé selon la revendication 1,
**caractérisé par le fait que** le circuit (1) contient un inverseur, la tension de commande (7) étant appliquée à une entrée d'inverseur, le potentiel de référence (5) à une première alimentation de tension d'inverseur et la deuxième tension (6) à une deuxième alimentation de tension d'inverseur.

3. Procédé selon la revendication 1 ou 2,
**caractérisé par le fait que** la différence de phase (11) est modifiée entre 150 et 210°.

4. Procédé selon l'une des revendications 1 à 3,
**caractérisé par le fait que** la mémoire à semi-conducteurs est une DRAM.
